# EUROPÄISCHE PATENTANMELDUNG

(11) **EP 1 248 507 A1**
(43) Veröffentlichungstag der Anmeldung: **09.10.2002**
(21) Anmeldenummer: 01107769.0
(22) Anmeldetag: 04.04.2001
(51) Int. Cl.: H05K 9/00, H05K 7/20

(54) **Hochfrequenzmodul eines Audio-Gerätes mit optimierter Wärmeableitung**

(71) Anmelder: Siemens Aktiengesellschaft, 80333 München (DE)
(72) Erfinder: Wieschhoff van Rijn, Reinhard, 78120 Rambouillet (FR)

(57) **Zusammenfassung**

Es wird ein Hochfrequenzmodul eines Audiogerätes, insbesondere eines Autoradios, mit mindestens einem Verlustwärme produzierenden elektrischen Bauelement (3) vorgeschlagen, das eine optimierte Wärmeabführung aufweist. Das Verlustwärme produzierende elektrische Bauelement (3) ist auf einer Leiterplatte (2) befestigt, die innerhalb eines als Hochfrequenzabschirmung ausgebildeten metallischen Gehäuses (1) angeordnet ist. Erfindungsgemäß ist vorgesehen, daß eine Innenfläche des Gehäuses (1) ein Wärmeleitelement (7) aufweist, das sich vom Gehäuse (1) zu dem Bauelement (3) hin erstreckt und eine wärmeleitende Verbindung zwischen dem Bauelement (3) und dem Gehäuse (1) herstellt.

## Beschreibung

Die Erfindung betrifft ein Hochfrequenzmodul eines Audio-Geräts mit mindestens einem Verlustwärme produzierenden elektrischen Bauelement, das auf einer Leiterplatte befestigt ist, die innerhalb eines als Hochfrequenzabschirmung ausgebildeten metallischen Gehäuses angeordnet ist.

Entsprechende Hochfrequenzmodule, bei denen es sich insbesondere um einen Tuner eines Radiogeräts handelt, weisen ein metallisches Abschirmgehäuse auf, um eine Beeinflussung anderer Bauelemente durch Hochfrequenzstrahlung zu vermeiden. Das Hochfrequenzmodul enthält in der Regel mehrere elektrische Bauelemente, die Verlustwärme erzeugen. Durch das als Hochfrequenzabschirmung ausgebildete Gehäuse wird die Abführung der Verlustwärme an die Umgebung erschwert, so daß innerhalb des Gehäuses hohe Temperaturen auftreten können, die zu einer Schädigung oder Zerstörung der elektrischen Bauelemente führen. Hochfrequenzmodule der oben beschriebenen Art sind beispielsweise aus der DE 199 26 763 A1 und der DE 196 36 181 A1 bekannt. Bei diesen bekannten Hochfrequenzmodulen finden sich keine besonderen Maßnahmen zur Optimierung der Wärmeableitung.

Aus der EP 0 489 341 A1 ist ein Gehäuse für elektrische Schaltungen bekannt, das eine verbesserte Wärmeableitung von Verlustwärme eines Bauelementes innerhalb des Gehäuses gewährleisten soll. Das Gehäuse ist insbesondere für kleine kompakte Schaltungen vorgesehen, die als selbständige Einheiten auf Schaltungs- oder Printplatten aufgebaut sind und zur Steuerung oder Regelung von elektrischen Antrieben, Motoren, Relais oder sonstigen anderen Baukomponenten dienen. Die die elektrischen Bauelemente tragende Platine befindet sich innerhalb eines in der Regel nicht vollständig geschlossenen Metallgehäuses. Zur Verbesserung der Wärmeabführung kann das Gehäuse mit einer Vergußmasse gefüllt werden, so daß eine erhöhte Wärmeleitung von einem beispielsweise Wärme produzierenden Leistungstransistor zu dem Metallgehäuse erfolgt. Ein solcher Verguß ist jedoch ein zusätzlicher Kostenfaktor und verhindert zudem eine Reparatur der Schaltung. Weiterhin ist nach der EP 0 489 341 A1 vorgesehen, daß eine offene Gehäusestelle durch einen Kühlkörper aus gut wärmeleitendem Material abgedeckt wird. Dieser Kühlkörper wird so angebracht, daß er direkt mit dem Wärme produzierenden Bauelement in Verbindung steht. Eine solche Ausführungsform erfordert jedoch eine hohe Maßgenauigkeit bei der Anordnung des Bauelements auf der Platine und der Platine innerhalb des Gehäuses, da bei einem verbleibenden Luftspalt zwischen dem Bauelement und dem Kühlkörper die gewünschte Wärmeabführung nicht gewährleistet ist. Um verbleibende Spalte ausschließen zu können, ist wiederum ein Verguß des Gehäuses vorgesehen.

Aufgabe der Erfindung ist es, ein Hochfrequenzmodul so weiterzubilden, daß eine verbesserte Abführung von Verlustwärme aus dem Gehäuseinneren erreicht wird.

Die Aufgabe wird bei einem erfindungsgemäßen Hochfrequenzmodul dadurch gelöst, daß eine Innenfläche des Gehäuses ein vom Gehäuse zu dem Bauelement sich erstreckendes Wärmeleitelement aufweist, das eine wärmeleitende Verbindung zwischen dem Bauelement und dem Gehäuse herstellt.

Das Abschirmgehäuse eines Hochfrequenzmoduls besteht aus einem metallischen Werkstoff. Metallische Werkstoffe weisen bekanntermaßen eine hohe Wärmeleitfähigkeit auf. Eine optimierte Wärmeabführung aus dem Inneren des Gehäuses kann daher dadurch erreicht werden, daß die Wärmequelle, nämlich ein Verlustwärme produzierendes Bauelement, über eine gut wärmeleitende Verbindung mit dem Gehäuse verbunden wird. Aufgrund der gegebenen hohen Wärmeleitfähigkeit des metallischen Abschirmgehäuses wird die dem Gehäuse zugeführte Verlustwärme gut auf das gesamte Gehäuse verteilt, so daß eine große Kühlfläche zur Verfügung steht. Wegen der bereits erwähnten hohen Wärmeleitfähigkeit von Metallen wird das Wärmeleitelement vorzugsweise als Metallelement ausgebildet sein.

Vorzugsweise ist das Wärmeleitelement fest mit dem Gehäuse verbunden. Hierdurch ergibt sich einerseits eine sehr gute Wärmeübertragung von dem Wärmeleitelement zum Gehäuse und andererseits eine sichere Fixierung des Wärmeleitelements. Vorzugsweise ist das Wärmeleitelement federnd ausgebildet. Hierdurch ist gewährleistet, daß das Wärmeleitelement stets mit einem gewissen Anpreßdruck an einer Fläche des Verlustwärme produzierenden Bauelementes anliegt. Zudem werden durch die federnde Ausgestaltung Abstandstoleranzen zwischen dem Gehäuse und dem Bauelement ausgeglichen.

In einer besonderen Ausführungsform ist vorgesehen, daß die das Wärmeleitelement aufweisende Fläche des Gehäuses einer Fläche der Leiterplatte zugewandt ist, auf der das Verlustwärme produzierende Bauelement angeordnet ist. Hierdurch wird eine einfache Ausgestaltung des Wärmeleitelementes sichergestellt. Aufwendige Formgebungen zur Erzielung einer Verbindung zwischen dem Bauelement und dem Gehäuse sind nicht erforderlich. Bei dieser Ausführungsform steht das Wärmeleitelement vorzugsweise in wärmeleitendem Kontakt mit einer von der Leiterplatte abgewandten Fläche des elektrischen Bauelements.

In einer weiteren Ausführungsform ist das Gehäuse mindestens zweiteilig ausgebildet und die Leiterplatte ist an einem ersten Gehäuseteil und das Wärmeleitelement an einem zweiten Gehäuseteil befestigt. Hierdurch ergibt sich eine besonders einfache Montage. Die Leiterplatte kann dabei zunächst in dem ersten Gehäuseteil befestigt werden und anschließend wird das zweite Gehäuseteil, das das Wärmeleitelement trägt, mit dem ersten Gehäuseteil verbunden. Bei entsprechender Anordnung des Wärmeleitelements wird bei diesem Verbindungsvorgang direkt auch die wärmeleitende Verbindung zwischen dem Wärmeleitelement und dem Bauelement auf der Leiterplatte hergestellt.

Bei dem Hochfrequenzmodul handelt es sich insbesondere um den Tuner eines Autoradios. In modernen Autoradios sind neben der reinen Radiofunktion weitere Funktionen wie beispielsweise die eines CD-Spielers oder eines Kassettenabspielgerätes integriert. Autoradios werden in genormten Abmessungen hergestellt, so daß sich eine hohe Dichte der einzelnen Module innerhalb des Autoradiogehäuses ergibt. Bei einem solchen kompakten Aufbau mit geringen Abständen zwischen den einzelnen Modulen ist sowohl die sichere Hochfrequenzabschirmung als auch die gute Wärmeableitung im Tuner von besonderer Bedeutung.

Bei dem Verlustwärme produzierenden Bauelement handelt es sich insbesondere um einen integrierten Schaltkreis, wie beispielsweise einen Tuner-IC.

Die Erfindung wird nachfolgend anhand eines Ausführungsbeispiels näher beschrieben. Es zeigen:
- Figur 1: einen schematischen Querschnitt eines Tunergehäuses
- Figur 2: eine Ansicht eines Gehäuseteils mit Wärmeleitelement
- Figur 3: eine Außenansicht eines Tunergehäuses
- Figur 4: wesentliche Komponenten eines Autoradios.

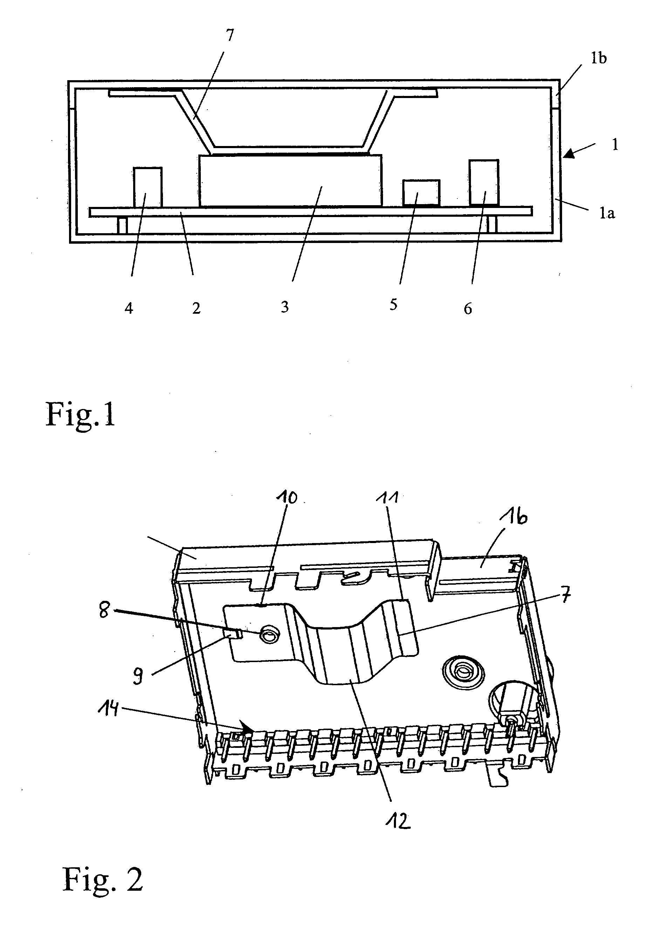

Figur 1 zeigt einen schematischen Querschnitt durch ein zweiteiliges Gehäuse 1 mit einem ersten Gehäuseteil 1a und einem zweiten Gehäuseteil 1b. Im ersten Gehäuseteil 1a ist eine Leiterplatte 2 befestigt. Die Leiterplatte 2 trägt neben einem Verlustwärme produzierenden Bauelement 3 weitere Bauelemente 4, 5, 6, die über nicht näher dargestellte Leiterbahnen zur Herstellung einer Schaltung elektrisch verbunden sind. An der Innenfläche des zweiten Gehäuseteils 1b ist ein Wärmeleitelement 7 befestigt, das im zusammengesetzten Zustand des Gehäuses 1 auf der Oberfläche des Bauelementes 3 aufliegt und somit eine wärmeleitende Verbindung zwischen dem Bauelement 3 und dem Gehäuse 1 herstellt. Zur weiteren Verbesserung des Wärmeübergangs zwischen dem Bauelement 3 und dem Wärmeleitelement kann Wärmeleitpaste o. dgl. auf das Bauelement 3 oder das Wärmeleitelement 7 aufgetragen sein.

Die vom Bauelement 3 produzierte Verlustwärme wird somit über das Wärmeleitelement 7 zum ebenfalls sehr gut wärmeleitenden Gehäuse 1 geleitet. Das Gehäuse 1 erfüllt daher erfindungsgemäß eine Doppelfunktion, und zwar nimmt das Gehäuse 1 neben der Abschirmfunktion auch die Funktion eines Kühlkörpers wahr. Durch die erfindungsgemäße Maßnahme kann die Temperatur innerhalb des Gehäuses 2 verringert werden, wodurch eine Schädigung der Bauelemente durch überhöhte Temperatur vermieden wird. Eine verringerte Temperatur wirkt sich zudem positiv auf die Lebensdauer der Bauelemente aus.

Figur 2 zeigt eine Innenansicht des zweiten Gehäuseteils 1b. Das Wärmeleitelement 7 ist mit einer Innenfläche des zweiten Gehäuseteils 1b direkt verbunden. Im Ausführungsbeispiel weist das Gehäuseteil 1b hierzu ein Fixierungselement 8 sowie ein Halteelement 9 auf. Das Wärmeleitelement 7 ist nur einseitig fest mit dem Gehäuseteil 1b verbunden, so daß zusammen mit der wellenförmigen Formgebung des Wärmeleitelements 7 eine federnde Wirkung erzielt wird. Das Wärmeleitelement 7 weist zwei Kontaktflächen 10, 11 zum Gehäuseteil 1b sowie eine Kontaktfläche 12 auf, die im zusammengebauten Zustand des Gehäuses an dem Wärme produzierenden Bauelement anliegt. Das zweite Gehäuseteil 1b weist darüber hinaus einen Antennenanschluß 13 und eine Kontaktleiste 14 auf, die jeweils mit der Leiterplatte verbunden werden und die Zu- und Abführung von Signalen zur Leiterplatte gewährleisten.

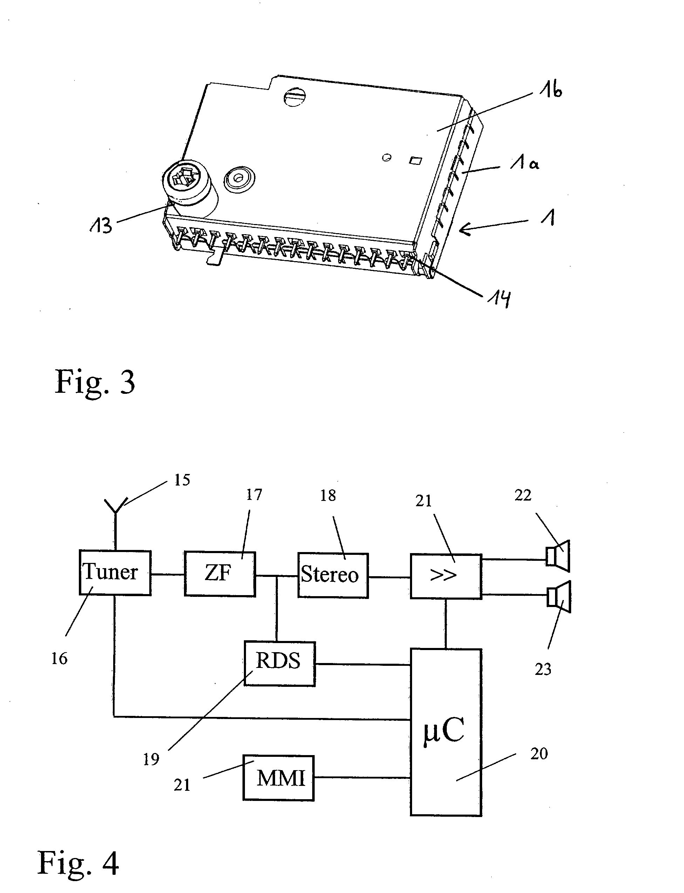

Figur 3 zeigt das Abschirmgehäuse im zusammengebautem Zustand. Durch das nahezu vollständig geschlossene Gehäuse wird eine gute Hochfrequenzabschirmung erzielt und gleichzeitig eine große Kühlfläche zur Verfügung gestellt. Bei einem solchen Hochfrequenzmodul kann es sich insbesondere um den Tuner eines Autoradios handeln. Über die Verbindungsleiste 14 wird dabei eine elektrische Verbindung zu den weiteren Komponenten des Autoradios hergestellt.

In Figur 4 sind einige wesentliche Komponenten eines bekannten Autoradios dargestellt. Durch die Antenne 15 werden Rundfunksignale von einem Rundfunksender empfangen. Die empfangenen Signale werden an einen Tuner 16 weitergeleitet. Das Ausgangssignal des Tuners 16 wird in der Zwischenfrequenzstufe 17 auf eine Zwischenfrequenz umgesetzt. Das Ausgangssignal der Zwischenfrequenzstufe 17 wird einem Stereo-Decoder 18 und einem RDS-Decoder 19 zugeführt. Der Tuner 16 wird von einem Steuerschaltkreis 20 angesteuert. Dem Steuerschaltkreis 20 werden Signale des RDS-Decoders 19 zugeführt. Weiterhin ist der Steuerschaltkreis 20 mit einem oder mehreren Ein-/Ausgabemodulen 21 (Bedienelemente, Display) verbunden. Ausgangssignale des Stereo-Decoders 18 und des Steuerschaltkreises 20 werden einem NF-Verstärker 21 zugeführt, dessen Ausgangssignale über die Lautsprecher 22, 23 als Audio-Signale akustisch wiedergegeben werden. Durch den Einsatz eines erfindungsgemäßen Hochfrequenzmoduls mit optimierter Wärmeableitung als Tuner 16 wird ein Beitrag zu einem sicheren und störungsfreien Betrieb des Autoradios geleistet.

## Patentansprüche

1. Hochfrequenzmodul eines Audiogeräts mit mindestens einem Verlustwärme produzierenden elektrischen Bauelement (3), das auf einer Leiterplatte (2) befestigt ist, die innerhalb eines als Hochfrequenz-Abschirmung ausgebildeten metallischen Gehäuses (1) angeordnet ist, **dadurch gekennzeichnet, daß** eine Innenfläche des Gehäuses (1) ein vom Gehäuse (1) zu dem Bauelement (3) sich erstreckendes Wärmeleitelement (7) aufweist, das eine wärmeleitende Verbindung zwischen dem Bauelement (3) und dem Gehäuse (7) herstellt.

2. Hochfrequenzmodul nach Anspruch 1, **dadurch gekennzeichnet, daß** das Wärmeleitelement (7) fest mit dem Gehäuse (1) verbunden ist.

3. Hochfrequenzmodul nach einem der vorhergehenden Ansprüche, **dadurch gekennzeichnet, daß** die das Wärmeleitelement (7) aufweisende Innenfläche des Gehäuses (1) einer Fläche der Leiterplatte (2) zugewandt ist, auf der das Verlustwärme produzierende Bauelement (3) angeordnet ist.

4. Hochfrequenzmodul nach einem der vorhergehenden Ansprüche, **dadurch gekennzeichnet, daß** das Wärmeleitelement (7) federnd ausgebildet ist.

5. Hochfrequenzmodul nach einem der vorhergehenden Ansprüche, **dadurch gekennzeichnet, daß** eine von der Leiterplatte (2) abgewandte Fläche des elektrischen Bauelements (3) mit dem Wärmeleitelement (7) in wärmeleitendem Kontakt steht.

6. Hochfrequenzmodul nach einem der vorhergehenden Ansprüche, **dadurch gekennzeichnet, daß** das Gehäuse (1) mindestens zweiteilig ausgebildet ist und die Leiterplatte (2) an einem ersten Gehäuseteil (1a) und das Wärmeleitelement (7) an einem zweiten Gehäuseteil (1b) befestigt ist.

7. Hochfrequenzmodul nach einem der vorhergehenden Ansprüche, **dadurch gekennzeichnet, daß** das Hochfrequenzmodul als Tuner ausgebildet ist.

8. Hochfrequenzmodul nach Anspruch 7, **dadurch gekennzeichnet, daß** es sich bei dem Tuner um einen Tuner eines Autoradios handelt.

9. Hochfrequenzmodul nach einem der vorhergehenden Ansprüche, **dadurch gekennzeichnet, daß** das elektrische Bauelement (3) ein integrierter Schaltkreis ist.
